# EUROPEAN PATENT APPLICATION

(11) **EP 0 797 306 A2**
(43) Date of publication of application: **24.09.1997**
(21) Application number: 96120202.5
(22) Date of filing: 16.12.1996
(51) Int. Cl.: H03M 1/06

(54) **Reception apparatus for A/D conversion of a received signal**

(30) Priority: 22.03.1996 JP 91811/96
(71) Applicant: KABUSHIKI KAISHA KENWOOD, Shibuya-ku Tokyo (JP)
(72) Inventor: Okuhata, Yasuhide, Yokohama-shi, Kanagawa (JP)
(74) Representative: Patentanwälte Leinweber & Zimmermann

(57) **Abstract**

A reception apparatus whose A/D converted digital signal does not contain a DC signal component. I and Q signals obtained by orthogonally demodulating a received signal are supplied via coupling capacitors 1 and 11 to A/D converters 2 and 12 to A/D convert the I and Q signals into digital signals which are supplied to a demodulator 31 to demodulate them. The output of the demodulator 31 is supplied to a DC component level detector 41 to detect DC component levels of the demodulated digital signals. The detected DC component levels are supplied to D/A converters 51 and 52 to convert them into analog signals. The DC bias values of the A/D converters 2 and 12 are controlled by the converted analog signal levels to eliminate the DC component from the digital signals converted by the A/D converters 2 and 12.

## Description

### BACKGROUND OF THE INVENTION

### 1. Field of the Invention

The present invention relates to a reception apparatus capable of receiving a digital audio broadcast signal, and more particularly to a reception apparatus capable of demodulating and reproducing a signal modulated through orthogonal frequency division multiplex.

### 2. Related Background Art

In a conventional reception apparatus of this type, a received signal is A/D converted and the A/D converted signal is demodulated through discrete Fourier transform.

In some cases, a DC signal component is contained in an A/D converted digital signal. For example, if an A/D converter operates with a single power supply, such a DC signal component appears if the power source voltage supplied to the A/D converter fluctuates.

If a DC signal component is contained in an A/D converted output digital signal, an overflow occurs when data is processed at the later stage and the other frequency components are adversely affected. Therefore, there is a problem of distortion in a reproduced output.

A reception apparatus taking such a problem into consideration has not been developed as yet.

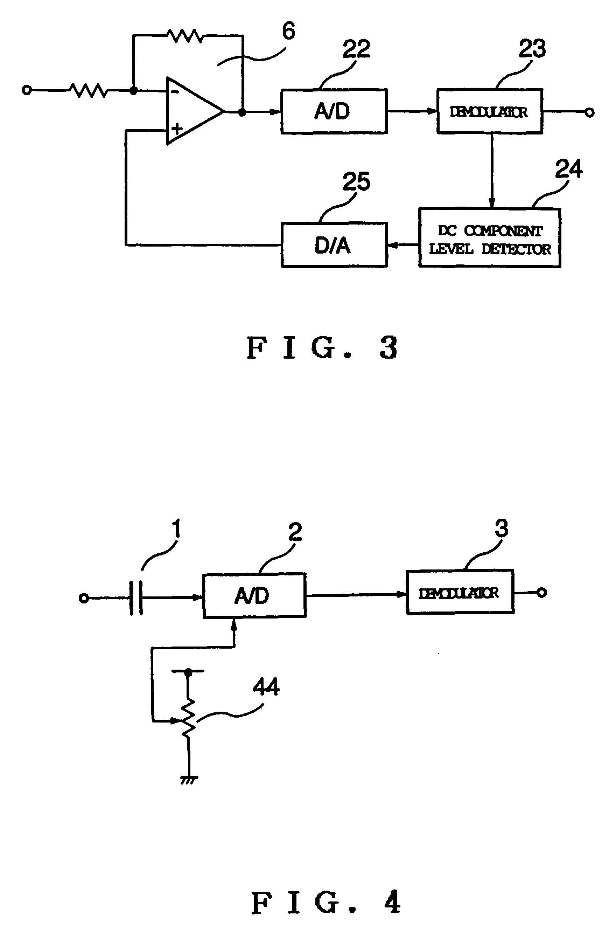

To solve this problem, the following countermeasure my be incorporated. For example, as shown in Fig. 4, a DC component of a received analog signal is cut by a coupling capacitor 1, an output of the coupling capacitor 1 is supplied to an A/D converter 2 to convert it into a digital signal, and this digital signal is demodulated by a demodulator 4 which performs FFT (fast Fourier transform) and the like for the demodulation. In another countermeasure, a DC bias of the A/D converter 2 is controlled in accordance with a DC voltage generated by a potentiometer 44 so that a DC signal component is not contained in the A/D converted digital signal.

However, the countermeasures illustrated in Fig. 4 use an open-loop control, and adjustment of the potentiometer is delicate and requires a cumbersome work. Furthermore, the level of the DC signal component contained in an A/D converted digital signal cannot be predicted so that adjustment becomes necessary for each modulator.

### SUMMARY OF THE INVENTION

It is an object of the present invention to provide a reception apparatus eliminating a DC signal component in an A/D converted digital signal.

The present invention provides a reception apparatus for A/D converting a received signal by an A/D converter and demodulating the A/D converted signal through discrete Fourier transform, wherein a DC bias of the A/D converter is controlled in accordance with a level of a DC signal component detected in data after the discrete Fourier transform to thereby eliminate the DC signal component from the A/D converted signal.

According to the invention, in the reception apparatus for A/D converting a received signal by an A/D converter and demodulating the A/D converted signal through discrete Fourier transform, a level of a DC signal component in the A/D converted signal subjected to the discrete Fourier transform is detected, and in accordance with the detected level of the DC signal component, the DC bias of the A/D converter is controlled to thereby eliminate the DC signal component from the A/D converted signal.

The present invention provides a reception apparatus wherein a received signal is supplied to one input terminal of a differential amplifier, an output of the differential amplifier is A/D converted, the A/D converted signal is demodulated through discrete Fourier transform, and in accordance with a level of a DC signal component detected from the A/D converted signal subjected to the discrete Fourier transform, a DC voltage to be supplied to the other input terminal of the differential amplifier is controlled to thereby eliminate the DC signal component from the A/D converted signal.

According to the invention, an output signal from the differential amplifier is A/D converted, and the A/D converted signal is demodulated through discrete Fourier transform. A level of the DC signal component in the A/D converted signal subjected to the discrete Fourier transform is detected, and in accordance with the detected level of the DC signal component, a DC voltage to be supplied to the other input terminal of the differential amplifier is controlled to thereby eliminate the DC signal component from the A/D converted signal.

### BRIEF DESCRIPTION OF THE DRAWINGS

Fig. 1 is a block diagram showing the structure of the main portion of a reception apparatus according to an embodiment of the invention.
Fig. 2 is a block diagram showing the structure of the main portion of a reception apparatus according to a first modification of the embodiment of the invention.
Fig. 3 is a block diagram showing the structure of the main portion of a reception apparatus according to a second modification of the embodiment of the invention.
Fig. 4 is a block diagram showing the structure of the main portion of a conventional reception apparatus.

### DETAILED DESCRIPTION OF THE PREFERRED EMBODIMENTS

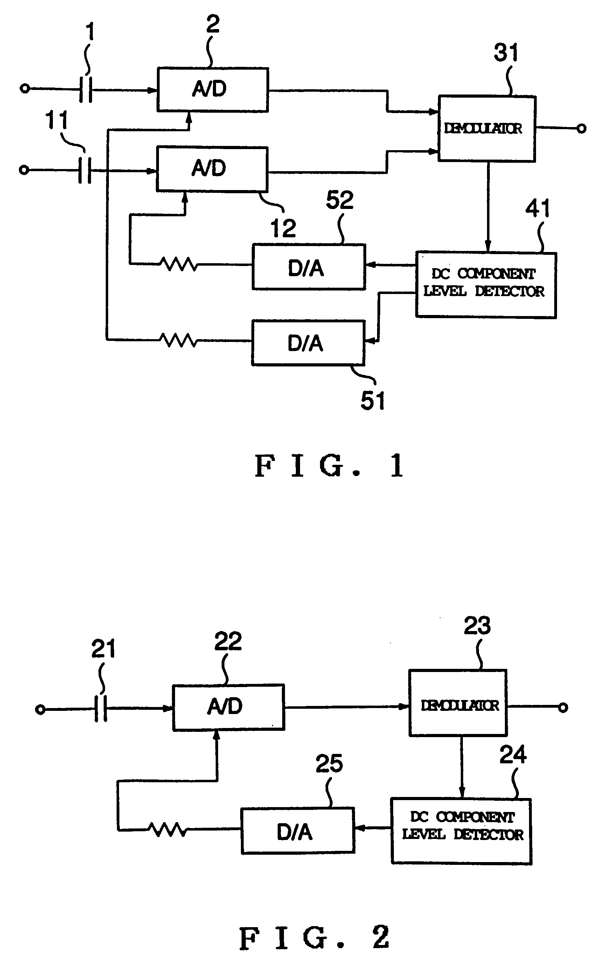

An embodiment of the reception apparatus of this invention will be described. Fig. 1 is a block diagram showing the structure of the main portion of a reception apparatus according to an embodiment of the invention.

In the reception apparatus of the embodiment, a received signal is frequency converted into an intermediate frequency signal which is orthogonally demodulated by an unrepresented orthogonal demodulator into orthogonal I and Q signals. The I signal is applied to a coupling capacitor 1 to remove its DC component. The I signal output from the coupling capacitor 1 is supplied to an A/D converter 2. The A/D converter 2 converts the input signal into a digital signal which is supplied to a demodulator 31. The demodulator 31 performs signal processing including FFT relative to the I digital signal converted by the A/D converter 2 to thereby demodulate the I signal.

Similarly, the Q signal is applied to a coupling capacitor 11 to remove its DC component. The Q signal output from the coupling capacitor 11 is supplied to an A/D converter 12. The A/D converter 12 converts the input signal into a digital signal which is supplied to the demodulator 31. The demodulator 31 performs signal processing including FFT relative to the Q digital signal converted by the A/D converter 12 to thereby demodulate the Q signal.

The number of samples per OFDM symbol used for obtaining digital signals of the I and Q signals is set to a value of 2 raised to the m-th power (where m is "11", for example).

Data obtained by the A/D converted, FFT processed digital I signal and data obtained by the A/D converted, FFT processed digital Q signal are supplied from the demodulator 31 to a DC component level detector 41 which detects DC components of the A/D converted, FFT processed digital I and Q signals.

The DC component of the A/D converted, FFT processed digital I signal detected by the DC component level detector 41 is supplied to a D/A converter 51 which converts the DC component into an analog signal. This analog signal is supplied to the A/D converter 2 to control the DC bias of the A/D converter 2 so that the DC signal component is eliminated from the digital I signal converted by the A/D converter 2.

The DC component of the A/D converted, FFT processed digital Q signal detected by the DC component level detector 41 is supplied to a D/A converter 52 which converts the DC component into an analog signal. This analog signal is supplied to the A/D converter 12 to control the DC bias of the A/D converter 12 so that the DC signal component is eliminated from the digital Q signal converted by the A/D converter 12.

In the reception apparatus of this embodiment constructed as above, the DC component of the I signal supplied to the coupling capacitor 1 is removed, and the I signal is converted into a digital signal by the A/D converter 2.

This digital signal output from the A/D converter 2 is demodulated by the demodulator 31 through a FFT process and the like. The FFT processed signal from the demodulator 31 is supplied to the DC component level detector 41 which detects the DC signal component of the FFT processed signal. This DC signal component is converted into an analog signal by the D/A converter 51.

The DC bias of the A/D converter 2 is controlled by the level of the converted analog signal so that the DC component can be eliminated from the digital I signal output from the A/D converter 2.

Similarly, the DC component of the Q signal supplied to the coupling capacitor 11 is removed, and the Q signal is converted into a digital signal by the A/D converter 12.

This digital signal output from the A/D converter 12 is demodulated by the demodulator 31 through a FFT process and the like. The FFT processed signal from the demodulator 31 is supplied to the DC component level detector 41 which detects the DC signal component of the FFT processed signal. This DC signal component is converted into an analog signal by the D/A converter 52.

The DC bias of the A/D converter 12 is controlled by the level of the converted analog signal so that the DC component can be eliminated from the digital Q signal output from the A/D converter 12.

As described above, in the reception apparatus of this embodiment, the number of samples per OFDM symbol for discrete Fourier transform is set to a value of 2 raised to the m-th power. Therefore, the DC signal component contained in a digital signal can be readily obtained from a discrete Fourier transformed output.

Next, a modification of the reception apparatus according to the embodiment of the invention will be described.

Fig. 2 is a block diagram showing the structure of the main portion of the reception apparatus according to a first modification of the embodiment of the invention.

In the reception apparatus of the first modification shown in Fig. 2, a received signal converted into an intermediate frequency signal is supplied to a coupling capacitor 21 to remove its DC component. The received signal output from the coupling capacitor 21 is supplied to an A/D converter 22 to convert the received signal into a digital signal. This digital signal from the A/D converter 22 is supplied to a demodulator 23 which performs processes including a FFT process relative to the digital signal to orthogonally and OFDM demodulate it.

The number of samples per OFDM symbol for obtaining a digital signal of the received signal is set to a value of 2 raised to the (m+1)-th power (m is "11" for example). Raising to the (m+1)-th power is carried out for orthogonal demodulation.

Data obtained by the A/D converted, FFT processed digital signal is supplied from the demodulator 23 to a DC component level detector 24 which detects a DC component of the A/D converted, FFT processed digital signal. The DC component of the A/D converted, FFT processed digital signal detected by the DC component level detector 24 is supplied to a D/A converter 25 which converts the DC component into an analog signal. This analog signal is supplied to the A/D converter 22 to control the DC bias of the A/D converter 22 so that the DC signal component is eliminated from the digital signal converted by the A/D converter 22.

In the reception apparatus of the first modification of the embodiment constructed as above, the DC component of the received signal supplied to the coupling capacitor 21 is removed, and this received signal is converted into a digital signal by the A/D converter 22. This digital signal output from the A/D converter 22 is demodulated by the demodulator 23 through an orthogonal demodulation, a FFT process, and the like.

The FFT processed signal from the demodulator 23 is supplied to the DC component level detector 24 which detects the DC signal component of the FFT processed signal. This DC signal component is converted into an analog signal by the D/A converter 25. The DC bias of the A/D converter 22 is controlled by the level of the converted analog signal so that the DC component can be eliminated from the digital signal output from the A/D converter 22.

Fig. 3 is a block diagram showing the structure of the main portion of the reception apparatus according to a second modification of the embodiment of the invention.

In the reception apparatus of the second modification, a received signal is input to an inverting input terminal of a differential amplifier 6 made of an operational amplifier, and an analog signal output from a D/A converter 25 is input to a non-inverting input terminal of the differential amplifier 6. An output of the differential amplifier 6 is supplied to an A/D converter 22 to convert it into a digital signal. This digital signal from the A/D converter 22 is supplied to a demodulator 23 which performs processes including an FFT process relative to the digital signal converted by the A/D converter 22 to orthogonally and OFDM demodulate the received signal.

The number of samples per OFDM symbol for obtaining a digital signal of the received signal is set to a value of 2 raised to the (m+1)-th power (m is "11" for example). Raising to the (m+1)-th power is carried out for orthogonal demodulation.

Data obtained by the A/D converted, FFT processed digital signal is supplied from the demodulator 23 to a DC component level detector 24 which detects a DC component of the A/D converted, FFT processed digital signal. The DC component of the A/D converted, FFT processed digital signal detected by the DC component level detector 24 is supplied to the D/A converter 25 which converts the DC component into an analog signal. This analog signal is supplied to the differential amplifier 6 to control it so that the DC signal component is eliminated from the digital signal converted by the A/D converter 22.

In the reception apparatus of the second modification of the embodiment constructed as above, even if there is a DC component in the received signal supplied to the inverting input terminal of the differential amplifier 6, this DC signal component is removed by the differential amplifier 6 so that the DC signal component is eliminated from the digital signal converted by the A/D converter 22.

As described so far, according to the reception apparatus of this invention for A/D converting a received signal by an A/D converter and demodulating the A/D converted signal through discrete Fourier transform, a DC bias of the A/D converter is automatically adjusted so that the DC signal component can be eliminated from the A/D converted signal. Accordingly, a DC signal component does not appear at an output of the A/D converter which component is otherwise generated by fluctuation of the power supply voltage, and distortions in the output are not generated.

According to the reception apparatus of this invention, a received signal is supplied to one input terminal of a differential amplifier, an output of the differential amplifier is A/D converted, the A/D converted signal is demodulated through discrete Fourier transform, and a level of a DC signal component detected from the A/D converted signal subjected to the discrete Fourier transform is supplied to the other input terminal of the differential amplifier. Accordingly, even if the received signal contains a DC component, the A/D converted digital data does not contain a DC component so that distortions are not generated in the output signal.

## Claims

1. A reception apparatus for A/D converting a received signal by an A/D converter and demodulating the A/D converted signal through discrete Fourier transform, wherein a DC bias of the A/D converter is controlled in accordance with a level of a DC signal component detected in data after the discrete Fourier transform to thereby eliminate the DC signal component from the A/D converted signal.

2. A reception apparatus wherein a received signal is supplied to one input terminal of a differential amplifier, an output of the differential amplifier is A/D converted, the A/D converted signal is demodulated through discrete Fourier transform, and in accordance with a level of a DC signal component detected from the A/D converted signal subjected to the discrete Fourier transform, a DC voltage to be supplied to the other input terminal of the differential amplifier is controlled to thereby eliminate the DC signal component from the A/D converted signal.
